# EUROPEAN PATENT APPLICATION

(11) **EP 4 585 952 A1**
(43) Date of publication of application: **16.07.2025**
(21) Application number: 24217964.6
(22) Date of filing: 06.12.2024
(51) Int. Cl.: G01R 33/483, G01R 33/565, G01R 33/567, G01R 33/561

(54) **MAGNETIC RESONANCE IMAGING APPARATUS, IMAGING METHOD, AND IMAGING PROGRAM FOR SIMULTANEOUS MULTISLICE IMAGING,**

(30) Priority: 12.01.2024 JP 2024003450
(71) Applicant: Canon Medical Systems Corporation, Tochigi 324-0036 (JP)
(72) Inventor: YUI, Masao, Otawara-shi, 324-0036 (JP)
(74) Representative: Marks & Clerk LLP

(57) **Abstract**

According to one embodiment, a magnetic resonance imaging apparatus (1) includes processing circuitry (51). The processing circuitry (51) designs (511) a first pulse sequence for a slice position relating to a first slice group and a slice for a navigator echo, the first slice group including a plurality of slices for multi-slice imaging by simultaneous multi-slice excitation. The processing circuitry (51) acquires (512) an echo signal by simultaneously exciting the first slice group and the slice for the navigator echo based on the first pulse sequence.

## Description

### FIELD

Embodiments described herein relate generally to a magnetic resonance imaging apparatus, an imaging method, and an imaging program.

### BACKGROUND

If a subject moves during imaging through MRI (magnetic resonance imaging), the image will be blurred or a ghost artifact will be generated in the image, resulting in degraded data quality. For example, if a head moves while successive imaging of the entire brain is being performed as in functional MRI (fMRI), one cannot ignore a signal variation caused by the positional shift in the slice direction and the in-plane direction if a user wishes to obtain a tiny signal variation in each region of the brain. Under these circumstances, there is a method in which additional signals called navigators are acquired, and the amount of the movement of the body or an organ of the subject is thereby calculated from the additional signals, and the imaging position in the next successive imaging is fine-tuned to substantially reduce the influence of the movement.

However, a pulse sequence of intended imaging is designed under tuned conditions in order to obtain a desired signal-to-noise ratio (SNR) or contrast. Thus, if one attempts to acquire navigator signals, the user needs to alternately perform intended imaging and acquisition of the navigator signals, resulting in decreased simultaneity of the timings of signal acquisition.

### SUMMARY

In relation to the foregoing embodiments, the following disclosures are additionally given as one aspect and selective features of the invention.

In an embodiment, a magnetic resonance imaging apparatus includes processing circuitry configured to:
design a first pulse sequence for a slice position relating to a first slice group and a slice for a navigator echo, the first slice group including a plurality of slices for multi-slice imaging by simultaneous multi-slice excitation; and
acquire an echo signal by simultaneously exciting the first slice group and the slice for the navigator echo based on the first pulse sequence.

In an embodiment, the processing circuitry may be further configured to perform motion correction on the echo signal based on the navigator echo; and generate a reconstructed image by performing multi-slice separation reconstruction on the echo signal subjected to the motion correction.

In an embodiment, the processing circuitry may be configured to correct a slice position of a second slice group based on the navigator echo, the second slice group including a plurality of slices for the multi-slice imaging by the simultaneous multi-slice excitation that is performed next to the imaging of the first slice group.

In an embodiment, the processing circuitry may be configured to design the slice for the navigator echo so as to position the slice for the navigator echo in a gap between adjacent slices of the first slice group.

In an embodiment, the processing circuitry may be further configured to: design a second pulse sequence corresponding to a slice position of a second slice group and the slice for a navigator echo, the second slice group including a plurality of slices for multi-slice imaging by simultaneous multi-slice excitation that is performed next to the imaging of the first slice group; and acquire an echo signal by simultaneously exciting the second slice group and the slice for a navigator echo based on the second pulse sequence relating to the second slice group.

In an embodiment, the processing circuitry may be further configured to design a flip angle relating to the slice for the navigator echo so as to make the flip angle relating to the slice for the navigator echo larger than a flip angle relating to each slice of the first slice group; and determine a heartbeat cycle using the navigator echo.

In an embodiment, the processing circuitry may be further configured to: design a flip angle relating to the slice for the navigator echo so as to make the flip angle relating to the slice for the navigator echo smaller than a flip angle relating to each slice of the first slice group, and determine a breathing cycle using the navigator echo.

In an embodiment, a magnetic resonance imaging apparatus includes processing circuitry configured to:
acquire an echo signal by exciting a slice for a navigator echo between intermittent acquisition processes using gradient echo in Fourier decomposition or phase-resolved functional lung (PREFUL); and
determine a heartbeat cycle or a breathing cycle using the navigator echo.

In an embodiment, the processing circuitry may be further configured to: perform multi-slice separation reconstruction on the echo signal; generate a reconstructed image; and perform image processing on the reconstructed image based on the navigator echo.

In an embodiment, the processing circuitry may be configured to perform, as the image processing, at least one of synchronization of body motion and pulsation, correction of the body motion and the pulsation, or analysis of a signal variation after the synchronization or the correction.

In an embodiment, an imaging method includes designing a first pulse sequence for a slice position relating to a first slice group and a slice for a navigator echo, the first slice group including a plurality of slices for multi-slice imaging by simultaneous multi-slice excitation; and
acquiring an echo signal by simultaneously exciting the first slice group and the slice for the navigator echo based on the first pulse sequence.

In an embodiment, the imaging method may include generating a reconstructed image by performing multi-slice separation reconstruction on the echo signal; and performing image processing on the reconstructed image based on the navigator echo.

In an embodiment, the imaging method may include performing, as the image processing, at least one of synchronization of body motion and pulsation, correction of the body motion and the pulsation, or analysis of a signal variation after the synchronization or the correction.

In an embodiment, an imaging program causes a computer to perform designing a first pulse sequence for a slice position relating to a first slice group and a slice for a navigator echo, the first slice group including a plurality of slices for multi-slice imaging by simultaneous multi-slice excitation; and
acquiring an echo signal by simultaneously exciting the first slice group and the slice for the navigator echo based on the first pulse sequence.

In an embodiment, the imaging program may cause the computer to perform generating a reconstructed image by performing multi-slice separation reconstruction on the echo signal; and image processing on the reconstructed image based on the navigator echo.

In an embodiment, the imaging program may cause the computer to perform, as the image processing, at least one of synchronization of body motion and pulsation, correction of the body motion and the pulsation, or analysis of a signal variation after the synchronization or the correction.

### BRIEF DESCRIPTION OF THE DRAWINGS

FIG. 1 is a diagram showing an example of a configuration of a magnetic resonance imaging apparatus according to an embodiment.
FIG. 2 is a flowchart showing a first example of an operation of the magnetic resonance imaging apparatus according to the embodiment.
FIG. 3 is a flowchart showing a second example of an operation of the magnetic resonance imaging apparatus according to the embodiment.
FIG. 4 is a diagram showing a first example of setting of an imaging slice according to the embodiment.
FIG. 5 is a diagram showing a second example of setting of an imaging slice according to the embodiment.
FIG. 6 is a diagram showing a third example of setting of an imaging slice according to the embodiment.
FIG. 7 is a diagram showing a fourth example of setting of an imaging slice according to the embodiment.
FIG. 8 is a diagram showing a fifth example of setting of an imaging slice according to the embodiment.

### DETAILED DESCRIPTION

In general, according to one embodiment, a magnetic resonance imaging apparatus includes processing circuitry. The processing circuitry designs a first pulse sequence for a slice position relating to a first slice group and a slice for a navigator echo, the first slice group including a plurality of slices for multi-slice imaging by simultaneous multi-slice excitation. The processing circuitry acquires an echo signal by simultaneously exciting the first slice group and the slice for the navigator echo based on the first pulse sequence.

Hereinafter, embodiments of a magnetic resonance imaging apparatus, an imaging method, and an imaging program will be described in detail with reference to the accompanying drawings. In the embodiments described below, elements assigned the same reference symbols are assumed to perform the same operations, and redundant descriptions thereof will be omitted as appropriate. An embodiment will be described below using the drawings.

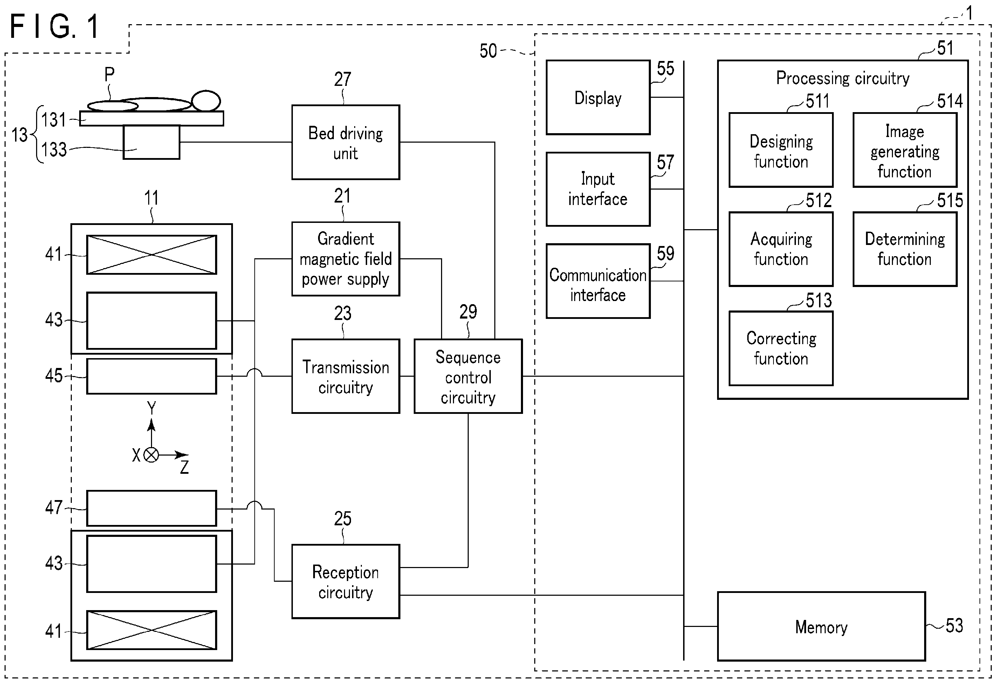

FIG. 1 is a block diagram showing an example of a configuration of a magnetic resonance imaging apparatus 1 according to an embodiment. As shown in FIG. 1, the magnetic resonance imaging apparatus 1 includes a gantry 11, a bed 13, a gradient magnetic field power supply 21, transmission circuitry 23, reception circuitry 25, a bed driving unit 27, sequence control circuitry 29, and a host computer 50.

The gantry 11 includes a static magnetic field magnet 41 and a gradient magnetic field coil 43. The static magnetic field magnet 41 and the gradient magnetic field coil 43 are accommodated in a housing of the gantry 11. The housing of the gantry 11 is formed with a bore having a hollow shape. A transmitter coil 45 and a receiver coil 47 are arranged in the bore of the gantry 11.

The static magnetic field magnet 41 has a hollow, approximately cylindrical shape, and generates a static magnetic field thereinside. Examples of the static magnetic field magnet 41 that are used include a permanent magnet, a superconducting magnet, or a normal conducting magnet. Here, a central axis of the static magnetic field magnet 41 is defined as a Z-axis, an axis vertically orthogonal to the Z-axis is defined as a Y-axis, and an axis horizontally orthogonal to the Z-axis is defined as an X-axis. The X-axis, Y-axis, and Z-axis constitute an orthogonal three-dimensional coordinate system.

The gradient magnetic field coil 43 is a coil unit attached to the inside of the static magnetic field magnet 41 and formed in a hollow, approximately cylindrical shape. The gradient magnetic field coil 43 receives a supply of a current from the gradient magnetic field power supply 21 to generate a gradient magnetic field. Specifically, the gradient magnetic field coil 43 includes three coils corresponding to the X-axis, the-Y axis, and the-Z axis, which are orthogonal to each other. The three coils form gradient magnetic fields in which the magnetic field intensity varies along the X-axis, the Y-axis, and the Z-axis, respectively. The gradient magnetic fields along the X-axis, the Y-axis, and the Z-axis are combined to form, in desired directions, a frequency encoding gradient magnetic field Gr, a phase encoding gradient magnetic field Gp, and a slice selection gradient magnetic field Gs, which are orthogonal to each other. The frequency encoding gradient magnetic field Gr is used to change the frequency of a magnetic resonance signal (MR signal) in accordance with a spatial position. The phase encoding gradient magnetic field Gp is used to change the phase of an MR signal in accordance with a spatial position. The slice selection gradient magnetic field Gs is used to discretionarily determine an imaging cross-section (slice). The following description is based on the premise that the gradient direction of the frequency encoding gradient magnetic field Gr aligns with the X-axis, the gradient direction of the phase encoding gradient magnetic field Gp aligns with the Y-axis, and the gradient direction of the slice selection gradient magnetic field Gs aligns with the Z-axis.

The gradient magnetic field power supply 21 supplies a current to the gradient magnetic field coil 43 in accordance with a sequence control signal from the sequence control circuitry 29. Through the supply of a current to the gradient magnetic field coil 43, the gradient magnetic field power supply 21 causes the gradient magnetic field coil 43 to generate gradient magnetic fields along the X-axis, the Y-axis, and the Z-axis. The gradient magnetic fields are superimposed on a static magnetic field formed by the static magnetic field magnet 41 and applied to a subject P.

The transmitter coil 45 is, for example, arranged inside the gradient magnetic field coil 43, and generates a high-frequency pulse (hereinafter, referred to as an "RF pulse") upon receiving a current supplied from the transmission circuitry 23.

The transmission circuitry 23 supplies a current to the transmitter coil 45 in order to apply an RF pulse for exciting a target proton existing in the subject P to the subject P via the transmitter coil 45. The RF pulse oscillates at a resonance frequency specific to the target proton to excite the target proton. An MR signal is generated from the excited target proton and is detected by the receiver coil 47. The transmitter coil 45 is, for example, a whole-body coil (WB coil). The whole-body coil may be used as a transmitter-receiver coil.

In response to an action of the RF pulse, the receiver coil 47 receives the MR signal generated from the target proton in the subject P. The receiver coil 47 has a plurality of receiver coil elements capable of receiving an MR signal. The received MR signal is supplied to the reception circuitry 25 either wirelessly or via a wire. Although not shown in FIG. 1, the receiver coil 47 has a plurality of reception channels arranged in parallel. Each reception channel has a receiver coil element for receiving an MR signal, an amplifier for amplifying the MR signal, etc. An MR signal is output from each reception channel. The total number of reception channels may be equal to, larger than, or smaller than the total number of receiver coil elements.

The reception circuitry 25 receives an MR signal generated from the excited target proton via the receiver coil 47. The reception circuitry 25 processes the received MR signal to generate a digital MR signal. The digital MR signal can be expressed by a k-space defined by spatial frequency. Thus, digital MR signals are referred to as "k-space data".

The transmitter coil 45 and the receiver coil 47 described above are mere examples. Instead of the transmitter coil 45 and the receiver coil 47, a transmitter-receiver coil having both a transmitting function and a receiving function may be used. Also, the transmitter coil 45, the receiver coil 47, and a transmitter-receiver coil may be combined.

The bed 13 is installed adjacently to the gantry 11. The bed 13 has a top board 131 and a base 133. The subject P is placed on the top board 131. The base 133 supports the top board 131 slidably along each of the X-axis, the Y-axis, and the Z-axis. The bed driving unit 27 is accommodated in the base 133. The bed driving unit 27 moves the top board 131 under the control of the sequence control circuitry 29. The bed driving unit 27 may include, for example, any motor such as a servo motor or a stepping motor.

The sequence control circuitry 29 controls the gradient magnetic field power supply 21, the transmission circuitry 23, and the reception circuitry 25 synchronously based on data acquisition conditions set by a designing function 511 of the processing circuitry 51, subjects the subject P to data acquisition corresponding to the data acquisition conditions, and acquires k-space data relating to the subject P. The data acquisition conditions define, for example, a pulse sequence, a magnitude of an electric current supplied from the gradient magnetic field power supply 21 to the gradient magnetic field coil 43, the timing of the supply of an electric current from the gradient magnetic field power supply 21 to the gradient magnetic field coil 43, a magnitude of an RF pulse supplied from the transmission circuitry 23 to the transmitter coil 45, the timing of the supply of an RF pulse from the transmission circuitry 23 to the transmitter coil 45, the timing of the reception of an MR signal at the receiver coil 47, etc.

As shown in FIG. 1, the host computer 50 is a computer that includes processing circuitry 51, a memory 53, a display 55, an input interface 57, and a communication interface 59.

The processing circuitry 51 has a processor such as a CPU, as a hardware resource. The processing circuitry 51 functions as the main unit of the magnetic resonance imaging apparatus 1. For example, the processing circuitry 51 executes various programs to implement a designing function 511, a acquiring function 512, a correcting function 513, an image generating function 514, and a determining function 515.

With the designing function 511, the processing circuitry 51 designs a data acquisition condition for a slice position relating to a first slice group that includes a plurality of slices for multi-slice imaging via simultaneous multi-slice excitation (SMS: simultaneous multi-band slice) and relating to a slice for a navigator echo. For example, with the designing function 511, the processing circuitry 51 designs a pulse sequence that includes the magnitude, the timing of application, etc., of gradient magnetic fields and RF pulses for simultaneous multi-slice excitation. The navigator echo is an echo signal used in a method for performing motion correction and synchronization using an MR signal obtained from a moving organ.

With the acquiring function 512, the processing circuitry 51 simultaneously excites the first slice group and the slice for a navigator echo (also referred to as a "navigator slice") based on the pulse sequence designed by the designing function 511, and acquires an echo signal.

With the correcting function 513, the processing circuitry 51 performs motion correction based on the navigator echo.

With the image generating function 514, the processing circuitry 51 performs multi-slice separation reconstruction on the echo signals acquired by the acquiring function 512.

With the determining function 515, the processing circuitry 51 performs various determinations. Also, with the determining function 515, the processing circuitry 51 determines a heartbeat cycle or a breathing cycle using the navigator echo.

The memory 53 is a storage device such as a hard disk drive (HDD), solid state drive (SSD), or integrated circuit storage device for storing various kinds of information. The memory 53 may also be, for example, a driver that reads and writes various kinds of information from and in a portable storage medium such as a CD-ROM drive, DVD drive, or flash memory. For example, the memory 53 stores data acquisition conditions, echo signals, navigator echoes, reconstructed images, control programs, and the like.

The display 55 displays various kinds of information. For example, a CRT display, a liquid crystal display, an organic EL display, an LED display, a plasma display, or any other display known in the relevant technical field can be suitably used as the display 55.

The input interface 57 includes an input device that receives various commands from a user. Examples of the input device that can be used include a keyboard, a mouse, various switches, a touch screen, and a touch pad. The input device is not limited to those provided with physical operational components such as a mouse and a keyboard. Examples of the input interface 57 also include electric signal processing circuitry that receives an electric signal corresponding to an input operation from an external input device provided separately from the magnetic resonance imaging apparatus 1, and outputs the received electric signal to various types of circuitry. The input interface 57 may also be a voice recognition device that acquires voice signals via a microphone and converts the voice signals into command signals.

The communication interface 59 is an interface that connects the magnetic resonance imaging apparatus 1 with a workstation, a picture archiving and communication system (PACS), a hospital information system (HIS), a radiology information system (RIS), etc., via a local area network (LAN), etc. The communication interface 59 transmits and receives various kinds of information to and from the connected workstation, PACS, HIS, and RIS.

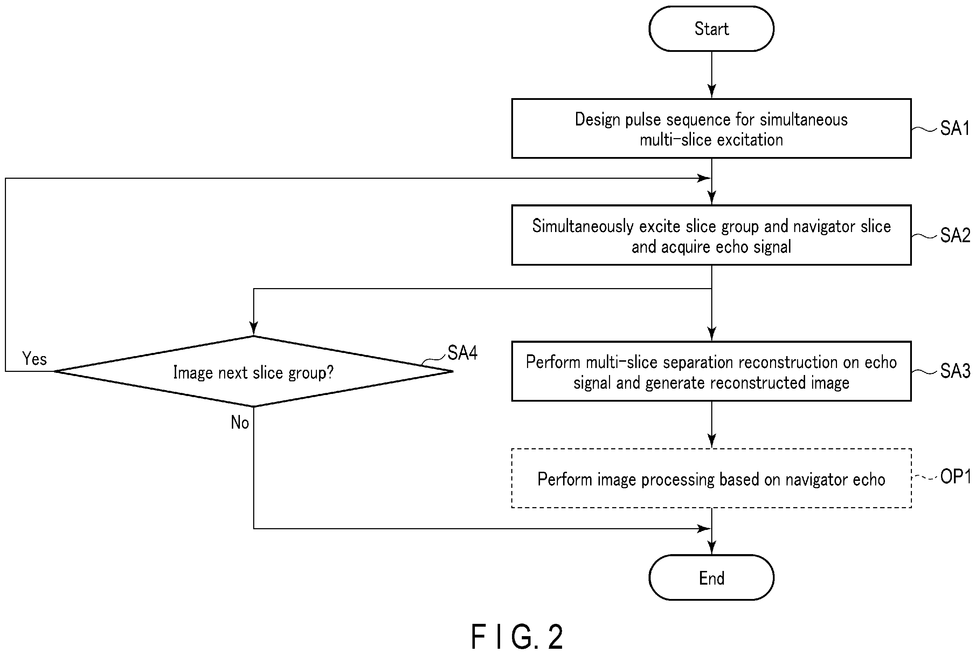

Next, a first example of an operation of the magnetic resonance imaging apparatus according to the embodiment will be described with reference to the flowchart of FIG. 2.

In step SA1, with the designing function 511, the processing circuitry 51 designs a pulse sequence for simultaneous multi-slice excitation. Specifically, the processing circuitry 51 designs a composite RF pulse for exciting the subject at frequencies corresponding to the slice positions of a slice group relating to simultaneous multi-slice excitation (also referred to as a "target slice") and a navigator slice for a navigator echo, and also designs a gradient magnetic field corresponding thereto. Since a method for designing a pulse sequence may use a designing method used in the simultaneous multi-slice excitation technique, description of the method for designing a pulse sequence will be omitted.

In step SA2, with the acquiring function 512, the processing circuitry 51 simultaneously excites the target slice relating to simultaneous multi-slice excitation and the navigator slice, and acquires echo signals. Specifically, with the acquiring function 512, the processing circuitry 51 may drive the gradient magnetic field coil 43 and the transmitter coil 45 via the sequence control circuitry 29 and acquire echo signals according to the data acquisition conditions based on the pulse sequence.

In step SA3, with the image generating function 514, the processing circuitry 51 performs multi-slice separation reconstruction on the echo signals corresponding to the respective slices and generates a reconstructed image. The multi-slice separation reconstruction may employ image reconstruction that applies parallel imaging (PI). That is, the echo signals obtained through excitation by a composite RF pulse are in a state where the echo signals of the respective slices overlap each other, resulting in an MR image in which the signals of the respective slices are superimposed onto each other. Therefore, an MR image corresponding to each slice may be generated by, for example, applying the techniques of GRAPPA (generalized autocalibrating partially parallel acquisition), CAIPIRINHA (controlled aliasing in parallel imaging results in higher acceleration) in the slice direction so as to separate the images corresponding to the respective slices.

In step SA4, with the determining function 515, the processing circuitry 51 determines whether or not to image the next slice group. For example, if an RF pulse relating to a slice group for simultaneous multi-slice excitation at the next slice position and a gradient magnetic field are designed as the data acquisition conditions by the designing function 511, it may be determined that the next slice group is imaged. If the next slice group is imaged, the process returns to step SA2, and the same process is repeated. On the other hand, if the next slice group is not imaged, the process ends.

As processing after step SA3, the processing circuitry 51, with the correcting function 513, may perform image processing on the echo signal corresponding to the target slice based on the navigator echo (OP1 in FIG. 2). Specifically, with the correcting function 513, the processing circuitry 51 separates a navigator echo corresponding to a navigator slice from a composite echo signal made by combining the echo signals of the respective slices upon simultaneous excitation. Based on the separated navigator echo, the reconstructed image is subjected to either synchronization or correction, or both synchronization and correction with respect to the body movement and pulsation caused by breathing, etc. The image processing OP1 may further perform a function of analyzing signal variations after the synchronization or correction.

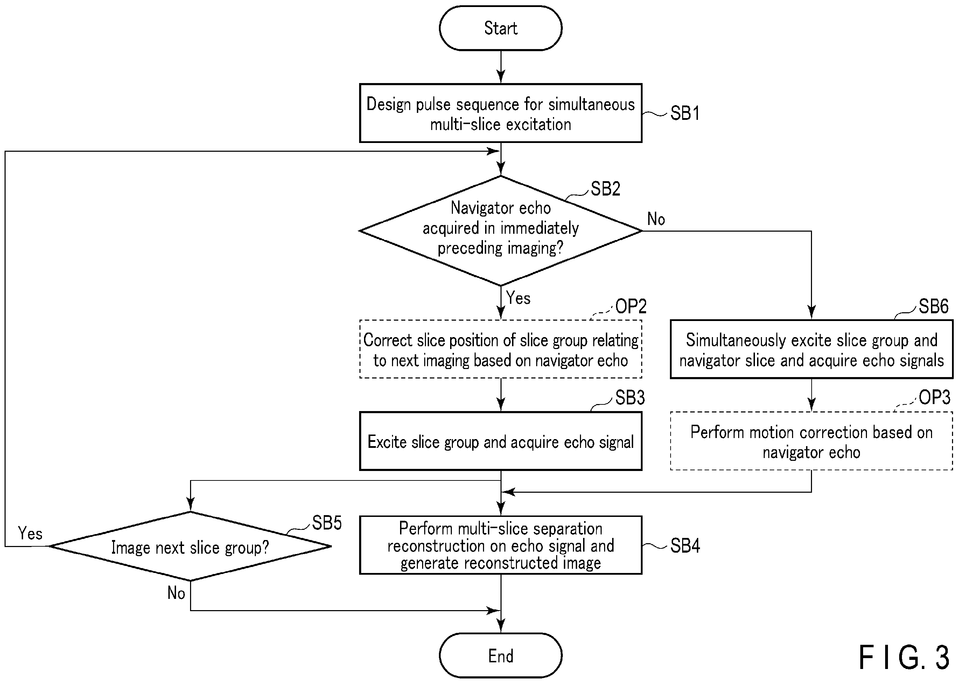

Next, a second example of an operation of the magnetic resonance imaging apparatus according to the embodiment will be described with reference to the flowchart of FIG. 3.

In step SB1, with the designing function 511, the processing circuitry 51 designs a pulse sequence for simultaneous multi-slice excitation in the same manner as in step SA1.

In step SB2, the processing circuitry 51 determines whether or not a navigator echo is acquired in the immediately preceding imaging. If a navigator echo is acquired, the process proceeds to step SB3, and if a navigator echo is not acquired, the process proceeds to step SB6.

In step SB3, with the acquiring function 512, the processing circuitry 51 excites a slice group and acquires echo signals.

In step SB4, with the image generating function 514, the processing circuitry 51 performs multi-slice separation reconstruction on the echo signals corresponding to the respective slices and generates a reconstructed image in the same manner as in step SA3.

In step SB5, with the determining function 515, the processing circuitry 51 determines whether or not to image the next slice group. If the next slice group is imaged, the process returns to step SB2, and the same process is repeated. On the other hand, if the next slice group is not imaged, the process ends. In a stage after step SB4 or step SB5, image processing corresponding to OP1 in FIG. 2 may be performed.

In step SB6, with the acquiring function 512, the processing circuitry 51 simultaneously excites a target slice relating to simultaneous multi-slice excitation and a navigator slice, and acquires echo signals since a navigator echo is not acquired in the immediately preceding imaging.

If Yes in step SB2, that is, if a navigator echo is acquired in the immediately preceding imaging, the processing circuitry 51, with the correcting function 513, may correct the slice position of the slice group for the next multi-slice imaging via simultaneous multi-slice excitation based on the navigator echo (OP2 in FIG. 3). Specifically, with the correcting function 513, the processing circuitry 51 may, for example, rearrange the echo signals corresponding to the target slices and select data used in the reconstruction in step SB4.

Likewise, as the processing after step SB6, the processing circuitry 51 may perform motion correction on the echo signals based on the navigator echo (OP3 in FIG. 3).

In this manner, the slice position of the slice group relating to the next imaging may be corrected based on the navigator echo acquired immediately preceding the imaging.

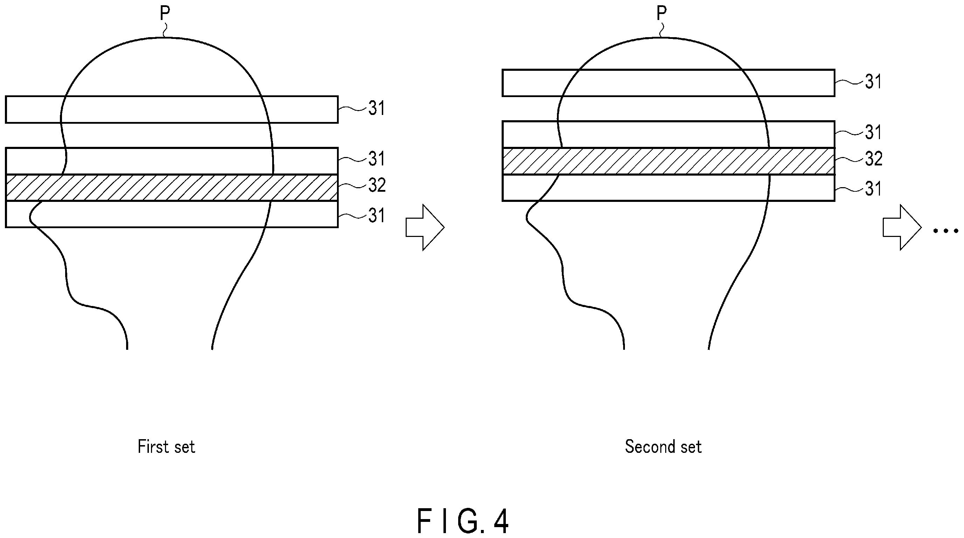

Next, a first example of setting an imaging slice according to the embodiment will be described with reference to FIG. 4.

FIG. 4 is a diagram showing a positional relationship between slices when two-dimensional volume imaging such as functional MRI (fMRI) is performed. FIG. 4 shows an example of imaging a range corresponding to the entire brain in the imaging of the first set and the second set of multiple slices for simultaneous multi-slice excitation. Successive imaging is performed by alternately repeating the imaging of the first set and the imaging of the second set.

FIG. 4 shows a sagittal section of the head of a subject P, and target slices 31 are set that respectively correspond to multiple slices that are imaging targets used in simultaneous multi-slice excitation. Herein, it is assumed that three different target slices 31 are simultaneously excited, but it suffices if there are two or more slice positions where the simultaneous excitation is performed. Further, the position of a navigator slice 32 is set in a gap between adjacent target slices 31. The position of the navigator slice 32 is not limited to a lower gap between the target slices 31 as shown in FIG. 4, and may be an upper gap between the target slices 31.

Also, in the example shown in FIG. 4, the navigator slice 32 and the target slices 31 are arranged without overlapping each other and without any space between them when observed in the body axis direction (slice direction); however, the arrangement is not limited thereto. For example, the navigator slice 32 and the target slice 31 adjacent thereto may partially overlap each other, or there may be a space between the navigator slice 32 and the target slice 31 adjacent thereto.

The positional relationship between the first set and the second set of slices is that the slice position of the second set is set on the upper side on the whole, as compared with the slice position of the first set. The positional relationship between the slice positions for each imaging is not particularly limited, and the same slice position may be successively imaged.

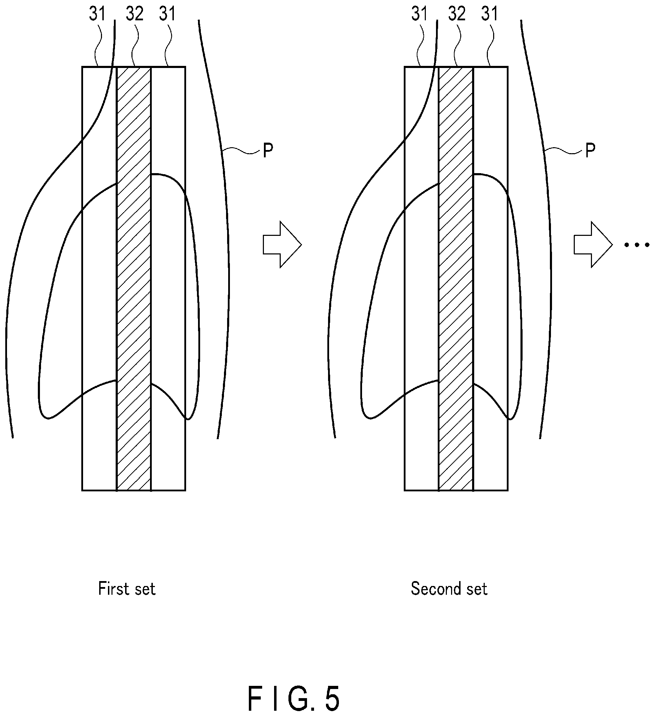

Next, a second example of setting an imaging slice according to the embodiment will be described with reference to FIG. 5.

FIG. 5 shows a positional relationship between slices when two-dimensional multi-slice imaging in simultaneous multi-slice excitation is repeated successively or intermittently to acquire signals.

Each of the first set and the second set in FIG. 5 shows the slice positions for the case where the chest of the subject P is imaged. Two target slices 31 relating to simultaneous multi-slice excitation and a navigator slice 32 in a gap between the two target slices 31 are set. Herein, it is assumed that imaging is repeated in the same slice position, but the positions of the target slices 31 may be varied for each imaging.

If the two-dimensional multi-slice imaging is gradient echo imaging, the processing circuitry 51, with the designing function 511, for example, sets a flip angle of the navigator slice 32 to be larger than a flip angle of the slice group relating to simultaneous multi-slice excitation (i.e., the target slices 31). Thus, the blood flow signals acquired from the navigator slice 32 become larger than the blood flow signals acquired from the target slices 31. As a result, the blood flow signals corresponding to the navigator slice become easy to see, allowing the processing circuitry 51, with the determining function 515, to determine the heartbeat cycle based on the navigator echo.

On the other hand, if the processing circuitry 51, with the designing function 511, sets a flip angle of the navigator slice 32 to be smaller than a flip angle of the target slices 31, the echo signals acquired from the slice position of the navigator slice 32 become smaller than the echo signals corresponding to the target slices 31. Therefore, with the determining function 515, the processing circuitry 51 can determine the breathing cycle based on the navigator echo.

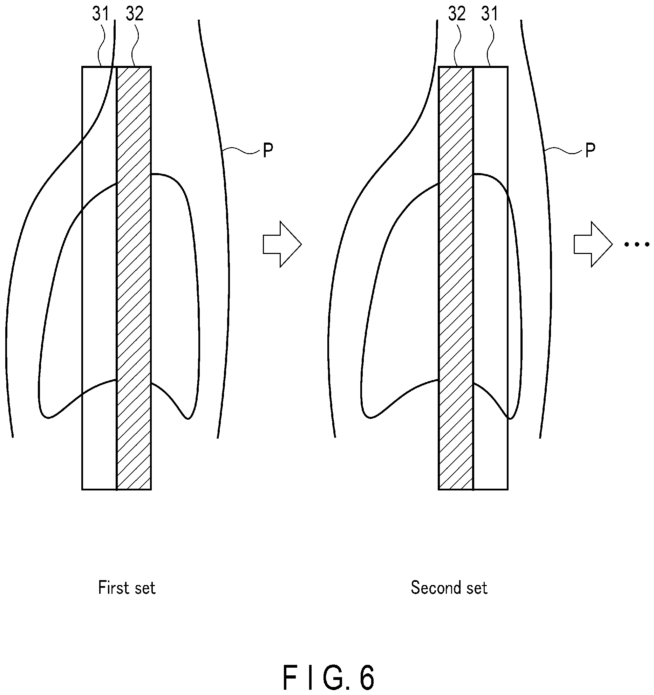

Next, a third example of setting an imaging slice according to the embodiment will be described with reference to FIG. 6.

FIG. 6 shows the case where the chest of the subject P is imaged, as in FIG. 5, but the slice position of the target slice 31 in the repeated imaging differs from that shown in FIG. 5.

In the first set, one target slice 31 used for image reconstruction and the navigator slice 32 are simultaneously excited. In the second set, the target slice 31 and the navigator slice 32 are simultaneously excited such that the position of the target slice 31 of the first set becomes symmetrical with respect to the navigator slice 32. In the example shown herein, one target slice 31 and the navigator slice 32 are simultaneously excited, but multiple target slices 31 may be excited.

In this manner, it is possible to simultaneously excite a target slice 31, which is a part of the slice group for simultaneous multi-slice excitation, and the navigator slice 32 while switching the target slices 31 for simultaneous multi-slice excitation in each imaging performed in the repeated imaging.

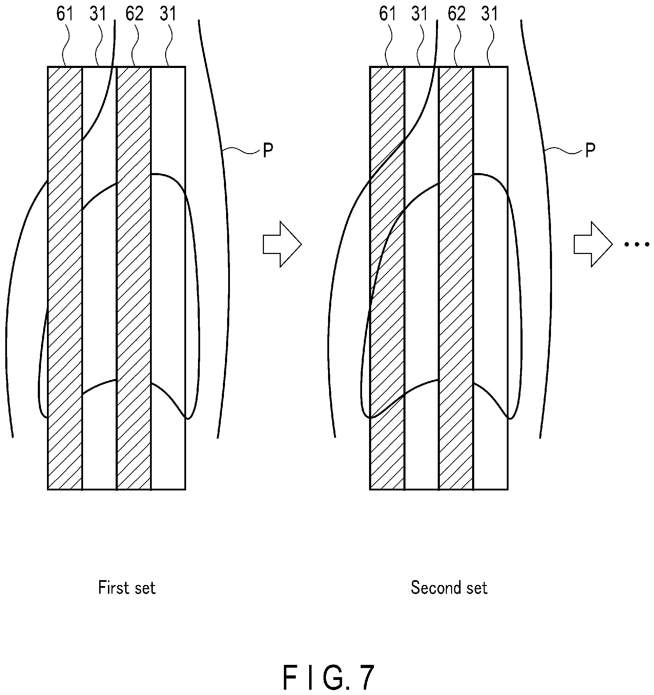

Next, a fourth example of setting an imaging slice according to the embodiment will be described with reference to FIG. 7.

FIG. 7 differs from FIGS. 5 and 6 in that two types of navigator slices are simultaneously excited. As shown in the first set and the second set in FIG. 7, in repeated imaging, a navigator slice 61 for determining a heartbeat cycle and a navigator slice 62 for determining a breathing cycle are simultaneously excited together with multiple target slices 31 for simultaneous multi-slice excitation.

The flip angle of the navigator slice 61 is set to be larger than the flip angle of the slices 31, and the flip angle of the navigator slice 62 is set to be smaller than the flip angle of the slices 31. The slice positions of the navigator slice 61 and the navigator slice 62 are assumed to be adjacent and parallel to the target slices 31, but these slice positions may be any position, provided that the navigator slices do not overlap each other when simultaneously excited. Thus, both a heartbeat cycle and a breathing cycle can be determined in the simultaneous excitation based on the two types of navigator echoes.

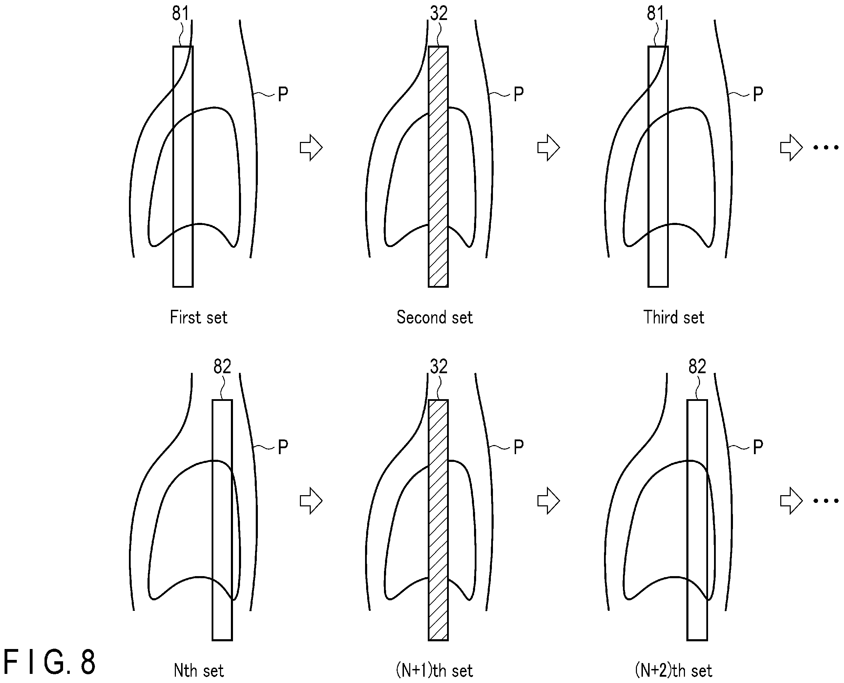

Next, a fifth example of setting an imaging slice according to the embodiment will be described with reference to FIG. 8.

FIG. 8 shows an example of acquiring navigator echoes between intermittent acquisition processes performed via transient GRE (gradient echo), which is a modification of Fourier decomposition (abbreviated as "FD") or phase-resolved functional lung (PREFUL) (both of which are hereinafter collectively referred to as "an FD method").

The FD method is ventilation/perfusion imaging via MRI which enables a respiratory function test to be conducted in a noninvasive manner instead of lung scintigraphy. The FD method has an advantage in that it can be performed without using a contrast agent and through free breathing.

First, echo signals corresponding to a target slice 81 are acquired in the first set. Navigator echoes corresponding to the navigator slice 32 are acquired in the second set. Echo signals corresponding to the same target slice 81 as that of the first set are acquired in the third set. In this manner, navigator echoes corresponding to the navigator slice 32 are acquired between the intermittent acquisition processes of echo signals corresponding to the target slice 81 (i.e., between the first set and the third set in FIG. 8). Likewise, navigator echoes corresponding to the navigator slice 32 are acquired between the intermittent acquisition processes of echo signals corresponding to a target slice 82, which is in a slice position different from that of the target slice 81 (i.e., between the Nth set and the (N+2)th set).

The navigator echoes relating to the navigator slice 32 are acquired via GRE with a small flip angle (low-flip GRE). Thus, the influence on a blood flow signal can be reduced, allowing for performance of intermittent acquisition in the same slice position.

According to the embodiment described above, a navigator slice is set between a plurality of target slices relating to multi-slice imaging via simultaneous multi-slice excitation, and the target slices and the navigator slice are simultaneously excited. In this manner, a slice for simultaneous multi-slice excitation and a navigator slice are simultaneously excited to acquire echo signals, whereby imaging time can be reduced, as compared to the case where the navigator echo is acquired separately from the slice for simultaneous multi-slice excitation. Furthermore, since a navigator slice for a navigator echo and a slice for simultaneous multi-slice excitation can be acquired at the same timing, the influence of the body motion can be effectively reduced. As a result, it is possible to reduce the time needed for the entire imaging and also possible to improve the image quality of an MR image corresponding to a target slice.

The term "processor" used in the above description means, for example, a CPU, a GPU, or circuitry such as an application specific integrated circuit (ASIC, a programmable logic device (e.g., a simple programmable logic device (SPLD), a complex programmable logic device (CPLD), or a field programmable gate array (FPGA)). The processor implements a function by reading and executing a program stored in storage circuitry. The program may be directly incorporated into the circuit of the processor instead of being stored in the storage circuit. In this case, the processor implements the function by reading and executing the program incorporated into the circuit. The function corresponding to the program may be realized by a combination of logic circuits, not by executing the program. Each processor of the present embodiment is not limited to be configured as single circuitry; multiple sets of independent circuitry may be integrated into a single processor that implements its functions. Furthermore, multiple components may be integrated into a single processor to implement the functions of the processor.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the invention as defined by the appended claims.

## Claims

1. A magnetic resonance imaging apparatus (1) comprising processing circuitry (51) configured to:
design (511) a first pulse sequence for a slice position relating to a first slice group and a slice for a navigator echo, the first slice group including a plurality of slices for multi-slice imaging by simultaneous multi-slice excitation; and
acquire (512) an echo signal by simultaneously exciting the first slice group and the slice for the navigator echo based on the first pulse sequence.

2. The magnetic resonance imaging apparatus (1) according to claim 1, wherein the processing circuitry (51) is further configured to:
perform (513) motion correction on the echo signal based on the navigator echo; and
generate (514) a reconstructed image by performing multi-slice separation reconstruction on the echo signal subjected to the motion correction.

3. The magnetic resonance imaging apparatus (1) according to claim 2, wherein the processing circuitry (51) is configured to correct (513) a slice position of a second slice group based on the navigator echo, the second slice group including a plurality of slices for the multi-slice imaging by the simultaneous multi-slice excitation that is performed next to the imaging of the first slice group.

4. The magnetic resonance imaging apparatus (1) according to claim 1, wherein the processing circuitry (51) is configured to design (511) the slice for the navigator echo so as to position the slice for the navigator echo in a gap between adjacent slices of the first slice group.

5. The magnetic resonance imaging apparatus (1) according to claim 1, wherein the processing circuitry (51) is further configured to:
design (511) a second pulse sequence corresponding to a slice position of a second slice group and the slice for a navigator echo, the second slice group including a plurality of slices for multi-slice imaging by simultaneous multi-slice excitation that is performed next to the imaging of the first slice group; and
acquire (512) an echo signal by simultaneously exciting the second slice group and the slice for a navigator echo based on the second pulse sequence relating to the second slice group.

6. The magnetic resonanceimaging apparatus (1) according to claim 1, wherein the processing circuitry (51) is further configured to:
design (511) a flip angle relating to the slice for the navigator echo so as to make the flip angle relating to the slice for the navigator echo larger than a flip angle relating to each slice of the first slice group; and
determine (515) a heartbeat cycle using the navigator echo.

7. The magnetic resonance imaging apparatus (1) according to claim 1, wherein the processing circuitry (51) is further configured to:
design (511) a flip angle relating to the slice for the navigator echo so as to make the flip angle relating to the slice for the navigator echo smaller than a flip angle relating to each slice of the first slice group, and
determine (515) a breathing cycle using the navigator echo.

8. The magnetic resonance imaging apparatus according to claim 1, wherein the processing circuitry is further configured to:
perform multi-slice separation reconstruction on the echo signal;
generate a reconstructed image; and
perform image processing on the reconstructed image based on the navigator echo.

9. The magnetic resonance imaging apparatus (1) according to claim 8, wherein the processing circuitry (51) configured to perform, as the image processing, at least one of synchronization of body motion and pulsation, correction of the body motion and the pulsation, or analysis of a signal variation after the synchronization or the correction.

10. An imaging method comprising:
designing a first pulse sequence for a slice position relating to a first slice group and a slice for a navigator echo, the first slice group including a plurality of slices for multi-slice imaging by simultaneous multi-slice excitation; and
acquiring an echo signal by simultaneously exciting the first slice group and the slice for the navigator echo based on the first pulse sequence.

11. The imaging method according to claim 10, further comprising:
generating a reconstructed image by performing multi-slice separation reconstruction on the echo signal; and
performing image processing on the reconstructed image based on the navigator echo.

12. The imaging method according to claim 11, further comprising performing, as the image processing, at least one of synchronization of body motion and pulsation, correction of the body motion and the pulsation, or analysis of a signal variation after the synchronization or the correction.

13. An imaging program including computer executable instructions, wherein the instructions, when executed by a processor, cause the processor to perform a method comprising:
designing a first pulse sequence for a slice position relating to a first slice group and a slice for a navigator echo, the first slice group including a plurality of slices for multi-slice imaging by simultaneous multi-slice excitation; and
acquiring an echo signal by simultaneously exciting the first slice group and the slice for the navigator echo based on the first pulse sequence.

14. The imaging program according to claim 13, causing the processor to perform a method further comprising:
generating a reconstructed image by performing multi-slice separation reconstruction on the echo signal; and
performing image processing on the reconstructed image based on the navigator echo.

15. The imaging program according to claim 14, causing the processor to perform a method further comprising performing, as the image processing, at least one of synchronization of body motion and pulsation, correction of the body motion and the pulsation, or analysis of a signal variation after the synchronization or the correction.
